# EUROPEAN PATENT APPLICATION

(11) **EP 4 572 084 A1**
(43) Date of publication of application: **18.06.2025**
(21) Application number: 24197189.4
(22) Date of filing: 29.08.2024
(51) Int. Cl.: H02J 7/00, H01M 10/42

(54) **COMMUNICATION APPARATUS FOR WIRELESS BATTERY MANAGEMENT SYSTEM**

(30) Priority: 11.12.2023 KR 20230178973
(71) Applicant: SAMSUNG SDI CO., LTD., Giheung-gu Yongin-si, Gyeonggi-do 17084 (KR)
(72) Inventor: Bae, Jin Cheol, 16678 Suwon-si, Gyeonggi-do (KR)
(74) Representative: Gulde & Partner

(57) **Abstract**

A communication apparatus for a wireless battery management system. The communication apparatus includes: a communication module; and a communication unit recognizing the communication module and communicating with the communication module using a communication method corresponding to the communication module, when the communication module is mounted on the communication unit, wherein the communication module is detachably mounted on the communication unit. The communication apparatus can reduce the time and cost required for development of hardware and software components of the wireless battery management system.

## Description

### BACKGROUND

### 1. Field

Aspects of embodiments of the present disclosure relate to a communication apparatus for a wireless battery management system.

### 2. Description of the Related Art

In order to distribute the load of a controller and achieve rapid and accurate monitoring of the condition of the entire battery pack, there has been proposed a wireless battery management system (wBMS) in which a slave controller is mounted on each of a predetermined number of battery modules incorporated in a battery pack and a master controller is deployed to control each slave controller.

Such a wireless battery management system includes a wireless battery system manager (wBSM) acting as a master and a wireless battery management module (wBMM) acting as a slave. The wBSM and the wBMM communicate with each other via a wireless communication channel established therebetween.

However, depending on the manufacturer providing a radio frequency integrated circuit (RF IC) for wireless communication to the wireless battery management system, a corresponding RF circuit needs to be individually applied to the wireless battery management system. That is, hardware and software components constituting the wireless battery management system need to be designed individually depending on the manufacture of the RF IC.

This section provides background information related to the present invention which is not necessarily prior art.

### SUMMARY

It is an aspect of the present invention to provide a communication apparatus for a wireless battery management system, which can reduce the time and cost required for development of hardware and software components of the wireless battery management system by modularizing a communication circuit to facilitate detachable mounting thereof, allowing automatic recognition of the communication circuit upon mounting of the communication circuit, and allowing communication based on results of recognition.

The above and other aspects and features of the present invention will become apparent from the following description of embodiments of the present invention.

In accordance with one aspect of the present invention, a communication apparatus for a wireless battery management system includes: a communication module; and a communication unit recognizing the communication module and communicating with the communication module using a communication method corresponding to the communication module, when the communication module is mounted on the communication unit, wherein the communication module is detachably mounted on the communication unit.

In other words, the communication method may be adapted to establish a communication with the communication module, when the communication module is mounted on the communication unit.

The communication unit may be disposed in a wireless battery system manager (wBSM) acting as a master in the wireless battery management system or in a wireless battery management module (wBMM) acting as a slave in the wireless battery management system.

When the communication module is mounted on the communication unit, the communication module may input a predetermined communication module signal to the communication unit and the communication unit may recognize the communication module based on the communication module signal.

The communication unit may include: a recognition signal input unit outputting a recognition signal corresponding to the communication module based on a communication module signal input from the communication module; and a controller recognizing the communication module based on the recognition signal from the recognition signal input unit and communicating with the communication module using a communication method corresponding to the recognized communication module.

The recognition signal input unit may include an AND gate outputting a recognition signal for the communication module by performing AND operation of the communication module signal and a reference signal input from a power terminal.

The communication apparatus may further include: a monitoring unit outputting a monitoring signal for monitoring an output signal from the recognition signal input unit.

The controller may determine that the recognition signal is a noisy signal when the monitoring signal falls within a noise voltage range corresponding to the recognition signal.

The communication method may be universal asynchronous receiver/transmitter (UART) communication or serial peripheral interface (SPI) communication.

In accordance with another aspect of the present invention, a communication apparatus for a wireless battery management system includes: a recognition signal input unit outputting a recognition signal corresponding to a communication module based on a communication module signal input from the communication module; and a controller recognizing the communication module based on an output signal from the recognition signal input unit and communicating with the communication module using a communication method corresponding to the recognized communication module.

The recognition signal input unit may include an AND gate outputting a recognition signal for the communication module by performing AND operation of the communication module signal and a reference signal input from a power terminal.

The communication apparatus may further include: a monitoring unit outputting a monitoring signal for monitoring the output signal from the recognition signal input unit.

The controller may determine that the recognition signal is a noisy signal when the monitoring signal falls within a noise voltage range corresponding to the recognition signal.

The communication method may be universal asynchronous receiver/transmitter (UART) communication or serial peripheral interface (SPI) communication.

The present invention provides a communication apparatus for a wireless battery management system, which can reduce the time and cost required for development of hardware and software components of the wireless battery management system by modularizing a communication circuit to facilitate detachable mounting thereof, allowing automatic recognition of the communication circuit upon mounting of the communication circuit, and allowing communication based on results of recognition.

However, aspects and features of the present invention are not limited to those described above and other aspects and features not mentioned will be clearly understood by those skilled in the art from the detailed description given below.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram of a communication apparatus for a wireless battery management system according to one or more embodiments of the present invention;
FIG. 2 is a diagram of a recognition module of a wBSM according to one or more embodiments of the present invention;
FIG. 3 and FIG. 4 are diagrams illustrating recognition of a communication module according to one or more embodiments of the present invention.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

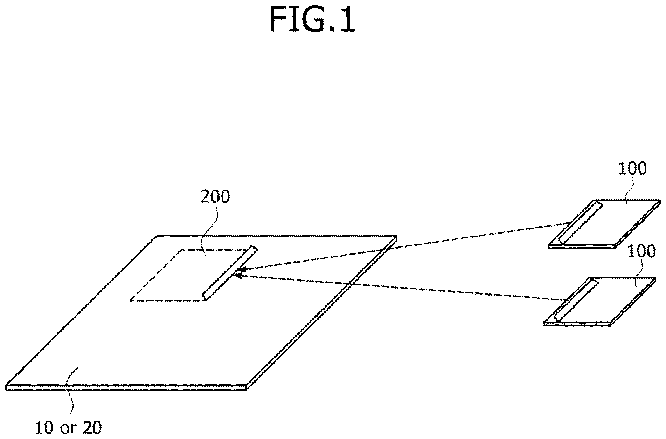

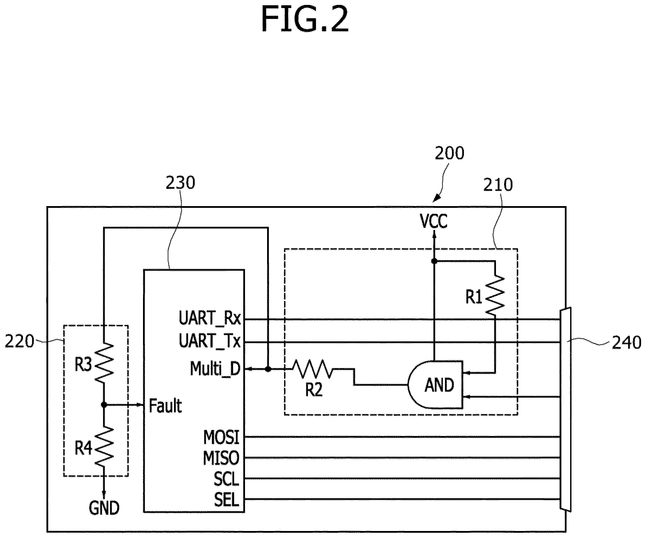

FIG. 1 is a block diagram of a communication apparatus for a wireless battery management system according to one or more embodiments of the present invention and FIG. 2 is a diagram of a recognition module of a wBSM according to one or more embodiment of the present invention.

Referring to FIG. 1, a communication apparatus for a wireless battery management system according to one embodiment of the present invention may include a communication module 100, and a communication unit 200.

The communication module 100 may communicate with a wireless battery system manager (wBSM) 10 acting as a master in the wireless battery management system or a wireless battery management module (wBMM) 20 acting as a slave in the wireless battery management system.

The communication module 100 may communicate using various communication methods. For example, the communication module 100 may communicate via universal asynchronous receiver/transmitter (UART) communication or serial peripheral interface (SPI) communication. However, the communication method of the communication module 100 is not particularly restricted.

The communication module 100 may be a modularized communication circuit detachably mounted on the communication unit 200 and may be attached to or detached from the communication unit 200 as needed.

The communication unit 200 may be installed in the wBSM 10 or the wBMM 20.

When the communication unit 200 is installed in the wBSM 10, the communication module 100 may communicate with the wBMM 20 via a wireless communication channel established therebetween.

When the communication unit 200 is installed in the wBMM 20, the communication module 100 may communicate with the wBSM 10 via a wireless communication channel established therebetween.

The communication module 100 may be of various types depending on the manufacturer or the like.

The type of communication module 100 mounted on the communication unit 200 may be varied depending on the communication target (for example, depending on whether the communication target is the wBSM 10 or the wBMM 20), the manufacturer of the wBSM 10 or the wBMM 20, or the communication method of the wBSM 10 or the wBMM 20.

The communication module 100 may be selectively mounted on the communication unit 200 as needed.

The communication module 100 may include a communication module signal input unit 110.

Upon mounting the communication module 100 to the communication unit 200, the communication module signal input unit 110 may input a predetermined communication module signal to the communication unit 200.

In some embodiments, the communication module signal input unit 110 may include a resistor Rm for input of a communication module signal, for example, a pull-up resistor for input of a high-level communication module signal or, in another example, a pull-down resistor for input of a low-level communication module signal. However, the method used by the communication module signal input unit 110 to input desired levels of communication module signals is not particularly restricted. For example, other combinations of active and/or passive electrical elements may be used.

The communication module signal input unit 110 may input communication module signals of different voltages to the communication unit 200 depending on the type of communication module 100. For example, a communication module 100 from manufacturer A may input a low-level communication module signal to the communication unit 200. As another example, a communication module 100 from manufacturer B may input a high-level communication module signal to the communication unit 200.

The communication unit 200 may recognize a currently mounted communication module 100 based on a communication module signal input therefrom and may communicate with the communication module 100 using a communication method set for the communication module 100. For example, upon receiving input of a low-level communication module signal, the communication unit 200 may recognize a currently mounted communication module 100 as the communication module 100 from manufacturer A. As another example, upon receiving input of the high-level communication module signal, the communication unit 200 may recognize a currently mounted communication module 100 as the communication module 100 from manufacturer B.

The communication method may be variously set depending on the type of communication module 100.

That is, as the communication module 100 may be selectively mounted on the single communication unit 200 and communicates with the communication unit 200 using a corresponding communication method, the time and cost required for development of the wireless battery management system can be reduced.

The communication unit 200 may be installed in the wBSM 10 or the wBMM 20.

The communication unit 200 may communicate with the communication module 100 via UART communication or SPI communication, without being limited thereto. That is, the communication method may be varied.

When the communication unit 200 is installed in the wBSM 10, the communication unit 200 may communicate with the communication module 100 via UART communication or SPI communication and the communication module 100 may communicate with the wBMM 20 via a wireless communication channel established therebetween.

When the communication unit 200 is installed in the wBMM 20, the communication unit 200 may communicate with the communication module 100 via UART communication or SPI communication and the communication module 100 may communicate with the wBSM 10 via a wireless communication channel established therebetween.

Referring to FIG. 2, the communication unit 200 may include a recognition signal input unit 210, a monitoring unit 220, a controller 230, and a connection part 240.

The connection part 240 may be connected to the communication module 100 to provide a communication interface.

The connection part 240 may be connected to the controller 230 via a communication interface line. The connection part 240 may provide the communication interface with the communication module 100 via the communication interface line.

In some embodiments, the connection part 240 may be a connector supporting the communication module 100. Alternatively, the connection part 240 may be connected to the communication module 100 by soldering or slotting. However, the method or structure used to connect the connection part 240 to the communication module 100 is not particularly restricted, that is, any one or more of a form-fitting connection, a force-fitting connection and/or materially bonded connection may be used.

The recognition signal input unit 210 may output a recognition signal corresponding to the communication module 100 based on a communication module signal input from the communication module 100.

The recognition signal input unit 210 may include a first resistor R1, a second resistor R2, and an AND gate.

The first resistor R1 may be connected at one side thereof to a VCC power terminal and may be connected at the other side thereof to an input terminal of the AND gate. The first resistor R1 may limit current from the VCC power terminal. The first resistor R1 may prevent overcurrent from being applied to the AND gate which may, for example, be caused by ambient disturbances. In other words, reliability may be improved.

The second resistor R2 may be connected at one side thereof to an output terminal of the AND gate and at the other side thereof to the controller 230. The second resistor R2 may limit current from the AND gate. The second resistor R2 may prevent overcurrent from being applied to the controller 230 which may, for example, be caused by ambient disturbances. In other words, reliability may be improved.

The AND gate may receive a reference signal from the VCC power terminal via the first resistor R1 and may receive a communication module signal from the communication module 100.

The AND gate may output a recognition signal by performing an AND operation of the reference signal and the communication module signal. The reference signal may be a high-level signal input from the VCC power terminal. In one or more embodiments, if the communication module signal is at a low level, the AND gate may output a low-level recognition signal and, when the communication module signal is at a high level, the AND gate may output a high-level recognition signal.

Since the communication module signal varies depending on the type of communication module 100, the AND gate may output different recognition signals depending on the type of communication module 100. Based on the recognition signal, the controller 230 may recognize the communication module 100 connected to the communication unit 200.

The monitoring unit 220 may monitor the recognition signal.

The monitoring unit 220 may be connected to an output terminal of the recognition signal input unit 210 to monitor the presence of noise in the recognition signal due to ambient disturbances.

The monitoring unit 220 may include a third resistor R3 and a fourth resistor R4 connected in series.

The third resistor R3 may be connected at one side thereof to the output terminal of the recognition signal input unit 210, for example, between the second resistor R2 and the controller 230, and may be connected at the other side thereof to the fourth resistor R4.

The fourth resistor R4 may be connected at one side thereof to ground and may be connected at the other side thereof to the third resistor R3.

The recognition signal from the recognition signal input unit 210 may be input to the controller 230 as a voltage divided by the third resistor R3 and the fourth resistor R4. The controller 230 may determine the presence of noise in the recognition signal based on the input divided voltage.

The controller 230 may recognize a communication module 100 currently mounted on the communication unit based on an output signal from the recognition signal input unit 210 and may communicate with the recognized communication module 100 using a communication method corresponding to the recognized communication module 100.

The controller 230 may receive a recognition signal from the recognition signal input unit 210 and may recognize the communication module 100 based on the recognition signal.

The controller 230 may recognize the communication module 100 by comparing a voltage level of the received recognition signal with each of the predetermined module voltage ranges.

Here, the predetermined module voltage range may refer to a reference voltage range for determination of which communication module 100 is currently mounted on the communication unit. That is, different module voltage ranges may be set for different communication modules 100.

For example, when the recognition signal is a low-level signal, the controller 230 may recognize a currently mounted communication module 100 as the communication module 100 from manufacturer A. In other embodiments, if the recognition signal is a high-level signal, the controller 230 may recognize a currently mounted communication module 100 as the communication module 100 from manufacturer B.

Upon recognizing the communication module 100, the controller 230 may communicate with the communication module 100 using a communication method set for the communication module 100. For example, the controller 230 may communicate with the communication module 100 from manufacturer A via a communication interface line for UART communication and may communicate with the communication module 100 from manufacturer B via a communication interface line for SPI communication.

The controller 230 may determine whether the recognition signal contains noise based on a monitoring signal that is input as a divided voltage to a fault terminal.

The controller 230 may determine the presence of noise in the recognition signal by comparing the divided voltage of the monitoring signal with a predetermined noise voltage range.

Here, the noise voltage range may refer to a reference voltage range for determination of the presence of noise in the recognition signal. That is, different noise voltage ranges may be set for different communication modules 100. For example, when the voltage of the monitoring signal falls within the noise voltage range set for a corresponding communication module 100, the controller 230 may determine that the recognition signal contains noise.

Upon determining that the recognition signal contains noise, the controller 230 may maintain communication using a communication method corresponding to the currently mounted communication module 100, thereby maintaining robust communication.

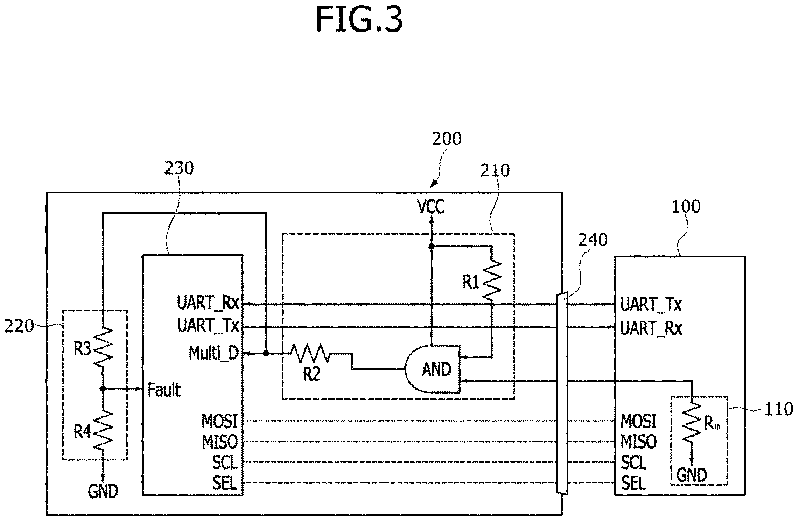

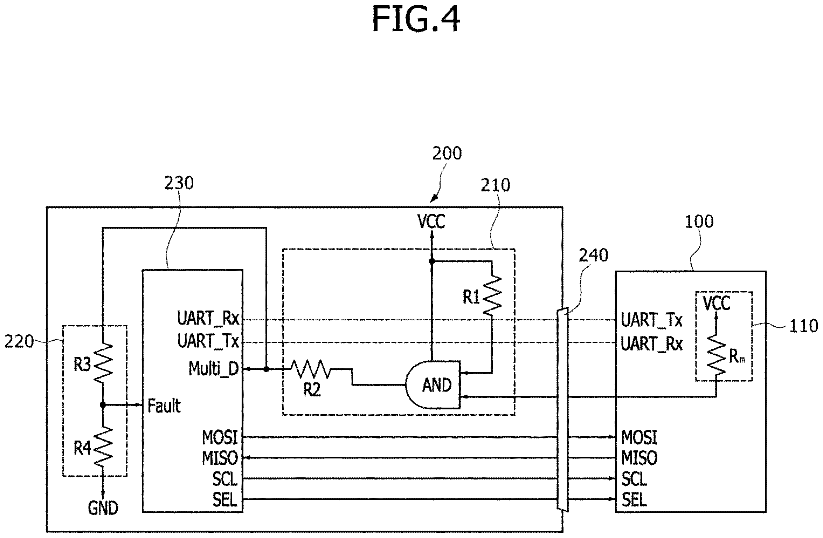

FIG. 3 and FIG. 4 are diagrams illustrating recognition of a communication module according to one or more embodiment of the present invention.

Referring to FIG. 3, when the communication module 100 from manufacturer A is mounted on the connection part 240, the communication module signal input unit 110 of the communication module 100 from manufacturer A may input a low-level communication module signal to the communication unit 200.

The AND gate of the recognition signal input unit 210 may output a low-level recognition signal by performing AND operation of the reference signal and the communication module signal.

The low-level recognition signal is, for example, input to a multi-D terminal of the controller 230. Then, the controller 230 may determine that the communication module 100 from manufacturer A is currently mounted on the communication unit by comparing the low-level recognition signal with each of the predetermined module voltage ranges.

The controller 230 may perform communication with the communication module 100 using a communication method corresponding to the communication module 100 from manufacturer A, for example, via a communication interface for UART communication.

In this process, even when the recognition signal contains noise due to, for example, ambient disturbances, the controller 230 may maintain communication with the communication module 100 from manufacturer A that is currently mounted on the communication unit, thereby maintaining robust communication.

Referring to FIG. 4, when the communication module 100 from manufacturer B is mounted on the connection part 240, the communication module signal input unit 110 of the communication module 100 from manufacturer B may input a high-level communication module signal to the communication unit 200.

The AND gate of the recognition signal input unit 210 may output a high-level recognition signal by performing an AND operation of the reference signal and the communication module signal.

The high-level recognition signal is, for example, input to the multi-D terminal of the controller 230. Then, the controller 230 may determine that the communication module 100 of the manufacturer B is currently mounted on the communication unit by comparing the low-level recognition signal with each of the predetermined module voltage ranges.

The controller 230 may communicate with the communication module 100 using a communication method corresponding to the communication module 100 from manufacturer B, for example, via a communication interface for SPI communication.

In this process, even when the recognition signal contains noise due to, for example, ambient disturbances, the controller 230 may maintain communication with the communication module 100 from manufacturer B that is currently mounted on the communication unit, thereby maintaining robust communication.

According to the embodiments of the present disclosure, the time and costs required for development of hardware and software components of a wBMM 20 can be reduced by modularizing a communication circuit to detachably mount the communication circuit on a wBSM 10, allowing the wBSM 10 to automatically recognize the communication circuit upon mounting the communication circuit on the wBSM 10, and allowing the communication circuit to communicate with the wBMM 20.

Although the present invention has been described with reference to some embodiments and drawings illustrating aspects thereof, the present invention is not limited thereto. Various modifications and variations can be made by a person skilled in the art to which the present invention belongs within the scope of the claims.

Depending on the manufacturer providing a radio frequency integrated circuit (RF IC) for wireless communication to the wireless battery management system, a corresponding RF circuit may need to be individually applied to the wireless battery management system. That is, hardware and software components constituting the wireless battery management system may need to be designed individually depending on the manufacture of the RF IC.

Embodiments herein provide a communication apparatus for a wireless battery management system, which can reduce the time and cost required for development of hardware and software components of the wireless battery management system by modularizing a communication circuit to facilitate detachable mounting thereof, allowing automatic recognition of the communication circuit upon mounting of the communication circuit, and allowing communication based on results of recognition.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made.

## Claims

1. A communication apparatus for a wireless battery management system, the communication apparatus comprising:
a communication module (100); and
a communication unit (200) configured to recognize the communication module (100) and communicate with the communication module (100) using a communication method corresponding to the communication module (100), when the communication module (100) is mounted on the communication unit (200),
wherein the communication module (100) is detachably mounted on the communication unit (200).

2. The communication apparatus according to claim 1, wherein the communication unit (200) is disposed in a wireless battery system manager, wBSM, (10) acting as a master in the wireless battery management system or in a wireless battery management module, wBMM, (20) acting as a slave in the wireless battery management system.

3. The communication apparatus according to claim 1 or 2, wherein, when the communication module (100) is mounted on the communication unit (200), the communication module (100) is configured to input a predetermined communication module signal to the communication unit (200) and the communication unit (200) is configured to recognize the communication module (100) based on the communication module signal.

4. The communication apparatus according to claim 3, wherein the communication unit (200) comprises:
a recognition signal input unit (210) configured to output a recognition signal corresponding to the communication module (100) based on the communication module signal input from the communication module (100); and
a controller (230) configured to recognize the communication module (100) based on the recognition signal from the recognition signal input unit (210) and communicate with the communication module (100) using a communication method corresponding to the recognized communication module (100).

5. The communication apparatus according to claim 4, wherein the recognition signal input unit (210) comprises an AND gate configured to output the recognition signal for the communication module (100) by performing an AND operation of the communication module signal and a reference signal input from a power terminal (VCC).

6. The communication apparatus according to claim 4 or 5, further comprising:
a monitoring unit (220) configured to output a monitoring signal for monitoring an output signal from the recognition signal input unit (210).

7. The communication apparatus according to claim 6, wherein the controller (230) is configured to determine that the recognition signal is a noisy signal when the monitoring signal falls within a noise voltage range corresponding to the recognition signal.

8. The communication apparatus according to any one of the previous claims, wherein the communication method is universal asynchronous receiver/transmitter, UART, communication or serial peripheral interface, SPI, communication.

9. The communication apparatus according to any one of the previous claims, wherein the recognition signal input unit (210) comprises a connection part (240) configure to be connected to the communication module (100) to provide a communication interface.

10. The communication apparatus according to claim 9, wherein the connection part (240) is connected to the controller (230) via a communication interface line, wherein the connection part (240) is configured to provide the communication interface with the communication module (100) via the communication interface line.

11. The communication apparatus according to any one of claims 5 to 10, wherein the recognition signal input unit (210) further comprises a first resistor (R1), a second resistor (R2).

12. The communication apparatus according to claim 11, wherein the first resistor (R1) is connected at one side thereof to the power terminal (VCC) and connected at the other side thereof to an input terminal of the AND gate.

13. The communication apparatus according to claims 11 or 12, wherein the second resistor (R2) is connected at one side thereof to an output terminal of the AND gate and at the other side thereof to the controller (230).

14. The communication apparatus according to any one of claims 11 to 13, wherein the AND gate receives a reference signal from the power terminal (VCC) via the first resistor (R1) and receives a communication module signal from the communication module (100).

15. The communication apparatus according to claim 6, wherein the monitoring unit (220) comprises a third resistor (R3) and a fourth resistor (R4) connected in series.
